# DEMANDE DE BREVET EUROPEEN

(11) **EP 0 524 038 A1**
(43) Date de publication de la demande: **20.01.1993**
(21) Numéro de dépôt: 92401707.2
(22) Date de dépôt: 18.06.1992
(51) Int. Cl.: H01L 23/495

(54) **Procédé de câblage entre des sorties de boîtier et des éléments d'hybride**

(30) Priorité: 05.07.1991 FR 9108456
(71) Demandeur: THOMSON-CSF, 75008 Paris (FR)
(72) Inventeur: Cayetano, José, F-92045 Paris la Défense (FR); Lemasson, Alain, F-92045 Paris la Défense (FR); Mur, Rémy, F-92045 Paris la Défense (FR)
(74) Mandataire: Benoit, Monique

(57) **Abrégé**

Procédé de câblage entre les sorties de boîtier et les éléments d'hybrides utilisant un clip (9, 10) préalablement mis en forme, équipé de brasure et prépositionné entre l'élément à câbler (4, 13) et la sortie correspondante (3) du boîtier (1). La soudure entre le clip (9, 10) et les éléments à câbler (3, 4, 15) est obtenue par refusion.

Application : hybridation de puissance

## Description

La présente invention se rapporte à l'encapsulation de circuits hybrides dans un boîtier, elle concerne plus particulièrement un procédé de câblage entre des sorties du boîtier et des éléments constitutifs du circuit hybride, à savoir des pistes sérigraphiées, des composants passifs ou des composants semi-conducteurs par exemple. Elle s'applique notamment aux hybrides de puissance où le câblage au niveau des sorties de boîtier nécessite des fils de fortes sections et plus généralement aux applications d'électronique de puissance soumises à des encombrements réduits tels les domaines de l'automobile, de l'aéronautique ou des activités spatiales par exemple.

Les boîtiers métalliques destinés aux hybrides de puissance sont profonds, ce qui complique le câblage à proximité des bords du boîtier et plus particulièrement au niveau des sorties. Par ailleurs, pour des raisons de fiabilité, les fils de connexion entre les sorties et les éléments à câbler doivent respecter un certain rayon de courbure, suffisamment grand. Cette contrainte introduit une perte de place sur les bords du boîtier, cette perte est encore accentuée par le fait qu'une plage de raccordement est nécessaire entre les sorties du boîtier et les composants dans le cas de soudure par ultra-son notamment, pour des raisons de compatibilité entre matériaux. La soudure par ultra-son est utilisée pour ses facilités de mise en oeuvre en évitant particulièrement l'utilisation des fers à souder.

Ces problèmes sont de plus compliqués par la circulation des forts courants qui imposent dans certains cas une multiplication des fils de connexion. Enfin, dans le cas de boîtiers de faible surface tels que les boîtiers du type TO254 fabriqués par la Société XERAM par exemple, ces problèmes deviennent aigus et remettent en cause la réalisation des hybrides.

Plusieurs solutions peuvent néanmoins être utilisées. Une première solution consiste à remplacer le fil de connexion de forte section par plusieurs fils de moindre section qui supportent un rayon de courbure plus faible. Cependant la taille des plages de raccordement en limite le nombre et le gain de place n'est pas suffisant. De plus, câbler plusieurs fils en parallèle augmente les coûts de réalisation. Une seconde solution permet la suppression de la plage de raccordement donc un gain de surface puisque le fil de connexion est câblé directement entre la sortie du boîtier et le composant ou sa plage d'accueil qui est généralement en or-platine. Néanmoins dans ce cas, il n'est pas possible de réaliser les soudures par ultra-son. Ce procédé nécessite en effet des surfaces en or. Il est donc nécessaire de recourir à une soudure de type classique, or la hauteur du boîtier empêche l'introduction du fer à souder à proximité des bords et même la soudure quand les boîtiers ont de trop faible surface. En fait, pour répondre à l'encombrement imposé, la solution actuelle consiste à utiliser des fils de connexion en aluminium, de diamètre suffisant pour les courants mis en jeu, avec de très faibles rayons de courbure, à la limite de la fiabilité. La mise en forme de ces fils est difficile. Les câblages ainsi réalisés sont ensuite éprouvés afin de mettre en évidence ceux qui sont défectueux. Le rendement obtenu est évidemment très médiocre. Par ailleurs, cette méthode nécessite deux dépôts, l'un en or pour le câblage filaire et l'autre en or-platine pour le brasage des composants et des substrats en céramique.

Elle nécessite donc une opération de montage de l'hybride par brasage, puis une opération de câblage filaire effectuée par des machines spécifiques et coûteuses.

Le but de l'invention est de pallier les inconvénients précités.

A cet effet, l'invention a pour objet un procédé selon la revendication 1.

L'invention a pour principaux avantages qu'elle permet de câbler les sorties du boîtier à des éléments situés au plus près des bords du boîtier, donc de répondre aux problèmes d'encombrement posés par les boîtiers d'hybride de puissance de faible surface notamment, qu'elle autorise à câbler directement sur les puces de semi-conducteurs, qu'elle nécessite un seul dépôt, en or-platine par exemple, qu'elle demande une seule opération réalisant à la fois le montage et le câblage, qu'elle permet pour les courants importants une seule connexion de forte section, qu'elle facilite la mise en forme des connexions, qu'elle n'exige pas de machine spécifique, enfin qu'elle apporte un très bon rendement de fabrication tout en diminuant les coûts correspondants.

D'autres caractéristiques et avantages de l'invention apparaîtront à l'aide de la description qui suit faite en regard des dessins annexés qui représentent :

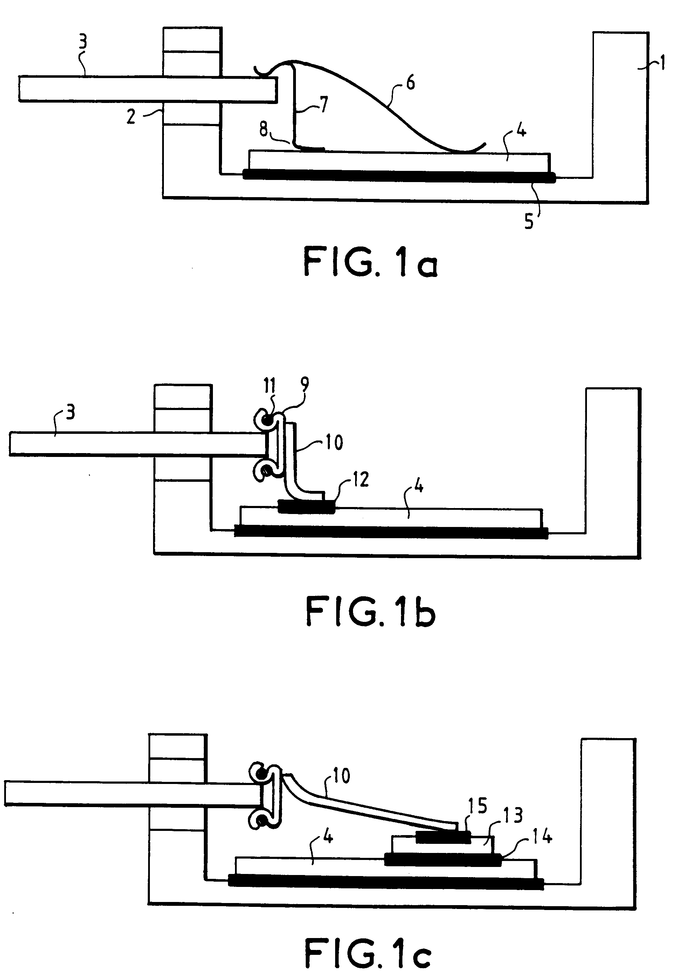

- la figure 1a, des profils de câblage ;
- la figure 1b, un premier type de câblage possible conformément au procédé selon l'invention ;
- la figure 1c, un deuxième type de câblage possible conformément au procédé selon l'invention.

La figure 1a représente une vue de boîtier 1 en coupe, muni d'une perle de verre 2 à travers laquelle est fixée une broche de sortie 3. Un substrat en céramique 4 est fixé sur le fond du boîtier par l'intermédiaire d'une brasure 5 à base d'étain par exemple. Le fil 6 correspond à un câblage correct et fiable entre une broche de sortie 3 et un élément sérigraphié du substrat 4 par exemple, mais dans ce cas, il ne répond pas aux contraintes d'encombrement. Le câblage 7 répond à ces contraintes mais le fil est fragilisé au niveau du talon 8. Le procédé selon l'invention permet de conserver ce profil de câblage 7 sans risque de fragilisation comme le montre la figure 1b. Suivant ce procédé, le fil 7 est remplacé par un clip conducteur préalablement mis en forme constitué d'une tête 9 pouvant s'enficher avec ou sans jeu sur la broche de sortie 3 et d'une queue 10 flexible en contact avec l'élément à câbler, par exemple dans le cas présent une plage d'accueil sérigraphiée sur le substrat 4 reliée à un composant semi-conducteur, non représentée sur la figure. Après mise en forme, le clip est équipé de brasure au niveau de sa tête et de sa queue, puis prépositionné entre la broche de sortie 3 et l'élément du substrat 4 à connecter. Durant la phase de montage le clip garde sa position grâce à l'effet de ressort exercé par sa queue 10. La brasure utilisée peut être la même que celle utilisée pour les substrats ou les composants,à base d'étain. Cette opération de prépositionnement du ou des clips est effectuée parallèlement aux autres opérations de montage des autres éléments de l'hybride. Une fois celles-ci terminées, l'ensemble de l'hybride peut être placé dans un four par exemple, la soudure entre le clip et les éléments à connecter est alors obtenue par refusion des brasures. La figure 1b présente une coupe de la soudure 11 entre la tête 9 du clip et la broche de sortie 3, et la soudure 12 entre la queue 10 du clip et la plage du substrat 4. Dans cet exemple de réalisation, la tête 9 du clip a une forme de pince ; lors de la refusion, la soudure 11 s'écoule sur la broche 3. Il apparaît bien que le procédé selon l'invention permet un montage-câblage qui ne nécessite qu'un type de dépôt pour les brasures et un seul passage au four.

La figure 1c présente un deuxième type de câblage possible conformément au procédé selon l'invention. Dans ce cas la queue 10 du clip est en contact directement avec l'élément 13 à câbler qui peut être un composant passif ou un composant semi-conducteur par exemple. Comme dans l'exemple précédent le clip est d'abord mis en forme puis prépositionné lors de l'opération de montage. Le composant 13 est fixé sur le substrat 4 par la brasure 14. La queue 10 du clip est fixée au composant par la soudure 15 obtenue par refusion. Cette solution permet de câbler des éléments très près du bord du boîtier, ces éléments peuvent être notamment des puces de semi-conducteur. Le clip peut être par exemple en cuivre-beryllium.

## Revendications

1. Procédé de câblage entre des sorties de boîtier et des éléments d'hybride contenus dans ce boîtier, caractérisé en ce que chaque connexion entre une sortie (3) et un élément à câbler (4, 13) est réalisée par un clip conducteur (9, 10) soudé sur la sortie (3) et sur l'élément à câbler (4, 13), le clip (9, 10) étant constitué d'une tête (9) et d'une queue (10) équipés de brasure, et étant péalablement mis en forme et prépositionné entre l'élément à câbler (4, 13) et la sortie (3) du boîtier (1), la tête (9) du clip s'enfichant sur la sortie (3) du boîtier (1) de l'hybride.

2. Procédé selon la revendication 1, caractérisé en ce que le clip (9, 10) est maintenu lors de la phase de prépositionnement par effet ressort exercé par la queue (10) du clip.

3. Procédé selon l'une quelconque des revendications précédentes, caractérisé en ce que la soudure entre le clip (9, 10) et les éléments à câbler (4, 13) d'une part et la sortie (3) d'autre part est obtenue par refusion.

4. Procédé selon l'une quelconque des revendications précédentes, caractérisé en ce que l'élément à câbler peut être une puce de semi-conducteur (13).

5. Procédé selon la revendication 1, caractérisé en ce que le dépôt de brasure sur le clip (9, 10) est à base d'étain.
